# EUROPEAN PATENT APPLICATION

(11) **EP 1 170 775 A1**
(43) Date of publication of application: **09.01.2002**
(21) Application number: 00915462.6
(22) Date of filing: 10.04.2000
(51) Int. Cl.: H01J 37/317, H01L 21/265

(54) **METHOD AND APPARATUS FOR ION IMPLANTATION**

(30) Priority: 09.04.1999 JP 10254599
(71) Applicant: Applied Materials, Inc., Santa Clara, California 95054 (US)
(72) Inventor: TAKADA, Koichi, Narita-shi, Chiba 286-8516 (JP); MIURA, Ryuichi, Narita-shi, Chiba 286-8516 (JP); MATSUNAGA, Yasuhiko, Narita-shi, Chiba 286-8516 (JP)
(74) Representative: Cross, Rupert Edward Blount
(86) International application number: JP0002325
(87) International publication number: WO0062326

(57) **Abstract**

In an ion implantation apparatus, a control unit first controls a wafer transfer robot to mount wafers on surfaces of wafer holders, and then controls a driving motor to open an open/close mechanism. Subsequently, ion implantation is carried out, and then, the driving motor is controlled to close the open/close mechanism, and the wafer transfer robot is controlled to remove the wafers from the respective wafer holders. Accordingly, since an ion beam from an ion beam generating section is blocked by the open/close mechanism, there does not occur such a state that the ion beam is implanted into a beam stop in a target chamber to produce particles.

## Description

### Technical Field

The present invention relates to an ion implantation apparatus and method for directing an ion beam to a wafer to implant ions therein.

### Background Art

In general, an ion implantation apparatus includes a beam line section for generating an ion beam, an ion implantation section for directing the ion beam from the ion beam generating section toward a silicon wafer to be processed to implant ions therein, and a wafer loader section for loading wafers into the ion implantation section.

The ion implantation section includes a target chamber the inside of which is evacuated under vacuum, and a wafer supporting unit is disposed in the target chamber . The wafer supporting unit has, for example, a swing shaft arrange swingably. The swing shaft is provided with a rotatable hub, from which a plurality of arms extend radially. Each arm has a wafer holder for holding a wafer at the distal end thereof. The wafer loader section has a load lock chamber the inside of which is evacuated under vacuum, and in which a wafer transfer robot for picking up a wafer stored in a wafer storage cassette and transferring the wafer to the position of the wafer holder is located.

In such an ion implantation apparatus, since the ion implantation into a wafer heats the wafer to a high temperature, a cooling water path is provided in the wafer holder and cooling water is made to flow through the cooling water path so as to cool the wafer held on the surface of the wafer holder.

When an ion implantation process is executed by the above-mentioned ion implantation apparatus, the ion beam from an ion beam-generating section are implanted into not only the wafer but also a beam stop provided in the target chamber. Thus, ions implanted in structural elements in the target chamber other than the wafer may cause sputtering and contamination.

Now, since it takes a certain degree of time to, for example, adjust a traveling direction of an ion beam at start-up of the ion beam, it is often the case that once the ion beam is started up, the ion beam is kept on radiating even in a period when the ion implantation is not carried out. In this case, however, since the surface of the wafer holder is in an exposed state, particles, atoms, molecules and the like produced by sputtering of the ion beam or the like may be deposited on the surface of the wafer holder. If in this condition, a wafer is mounted on the surface of the wafer holder to carry out the ion implantation, a clearance will be present between the rear surface of the wafer and the surface of the wafer holder, so as to fail to obtain excellent thermal conductivity between them. As a result, wafer cooling efficiency will be degraded.

An object of the present invention is to provide an ion implantation apparatus and method which can reduce contaminants on a wafer holder and improve the cooling efficiency of a wafer.

### Disclosure of the Invention

For accomplishing the above object, the present invention is characterized by an ion implantation apparatus comprising: a target chamber under vacuum inside; a wafer holder disposed in the target chamber; ion beam generating means for generating an ion beam to be radiated to a wafer held by the wafer holder; an open/close mechanism disposed between the target chamber and the ion beam generating means, for passing and blocking the ion beam from the ion beam generating means; driving means for opening and closing the open/close mechanism; a load lock chamber disposed adjacent to the target chamber and kept under vacuum inside; wafer transfer means disposed in the load lock chamber; and control means for controlling the driving means and the wafer transfer means, wherein the control means controls the driving means and the wafer transfer means so that the open/close mechanism is opened after the wafer is held by the wafer holder, and the control means controls the driving means and the wafer transfer means so that the wafer is dismounted from the wafer holder after the open/close mechanism is closed.

In the present invention constructed as described above, before the ion beam is radiated to the wafer to carry out the ion implantation, the wafer transfer means is controlled so that the wafer is held by the wafer holder, and then, the driving means is controlled to open the open/close mechanism, and when the ion implantation to the wafer is ended, the driving means is controlled to close the open/close mechanism, and the wafer transfer means is controlled to remove the wafer from the wafer holder. Accordingly, in a period from the end of one ion implantation process to the start of a next ion implantation process, the ion beam from the ion beam generating means is blocked by the open/close mechanism and does not reach the wafer holder. Thus, even if the surface of the wafer holder is put in an exposed state by removing the wafer from the wafer holder, there hardly occurs such a state that contaminants produced by implantation of the ion beam into a beam stop attach to the surface of the wafer holder. Thus, when a wafer is mounted on the surface of the wafer holder in the next ion implantation process, substantially the whole of the rear surface of the wafer can come in contact with the surface of the wafer holder. Therefore, excellent thermal conductivity between the wafer and the wafer holder can be obtained, and the cooling efficiency of the wafer by cooling water is improved.

In the above-mentioned ion implantation apparatus, preferably, the control means controls the driving means and the wafer transfer means so that after the wafer is dismounted from the wafer holder, a dummy wafer is held by the wafer holder, and the open/close mechanism is opened. As the result, a time in which the open/close mechanism is closed can be made short.

In this case, preferably, the control means monitors whether or not a new wafer to be continuously subjected to ion implantation exists in the load-lock chamber after the processed wafer is dismounted from the wafer holder, and when it is determined that the new wafer exists, the control means controls the driving means and the wafer transfer means so that the open/close mechanism is opened after the new wafer is held by the wafer holder, and when it is determined that the new wafer does not exist, the control means controls the driving means and the wafer transfer means so that the open/close mechanism is opened after the dummy wafer is held by the wafer holder. By this, when the new wafer to be continuously subjected to ion implantation exists in the load lock chamber, the wafer is immediately held by the wafer holder, so that an ion implantation process can be effectively carried out.

Further, in order to achieve the above object, the present invention provides an ion implantation apparatus comprising: a target chamber under vacuum inside; a wafer holder disposed in the target chamber; ion beam generating means for generating an ion beam to be radiated to a wafer held by the wafer holder; an open/close mechanism disposed between the target chamber and the ion beam generating means, for passing and blocking the ion beam from the ion beam generating means; driving means for opening and closing the open/close mechanism; and control means for controlling the driving means so that the open/close mechanism is closed when the wafer is dismounted from the wafer holder. With this arrangement, as described above, there hardly occurs such a state that contaminants to the wafer holder in a period between the ion implantation and the next ion implantation, and the cooling efficiency of a wafer by cooling water is improved.

Moreover, in order to achieve the above object, another aspect of the present invention is characterized by an ion implantation method for carrying out ion implantation by using an ion implantation apparatus having a target chamber under vacuum inside, a wafer holder disposed in the target chamber, ion beam generating means for generating an ion beam to be radiated to a wafer held by the wafer holder, and an open/close mechanism disposed between the target chamber and the ion beam generating means, for passing and blocking the ion beam from the ion beam generating means, the ion implantation method comprises: a first step of opening the open/close mechanism after the wafer is held by the wafer holder; a second step of carrying out ion implantation by radiating the wafer with the ion beam; and a third step of dismounting the wafer from the wafer holder after the open/close mechanism is closed when the ion implantation to the wafer is completed, wherein the first to third steps are carried out repeatedly while radiation of the ion beam is maintained. In this moethod, since contaminants hardly deposit to the wafer holder during a period of transition from the third step to the first step, when a wafer is held by the wafer holder at the time of next ion implantation, the cooling efficiency of the wafer by cooling water is improved.

The above ion implantation method preferably further includes a fourth step of opening the open/close mechanism after a dummy wafer is held by the wafer holder, between the third step and the first step. By this, as described above, a time in which the open/close mechanism is closed can be made short.

Further, in order to achieve the above object, according to another aspect of the present invention, an ion implantation method for carrying out ion implantation by radiating a wafer held by each of a plurality of wafer holders with an ion beam from ion beam generating means is characterized in that in a case where the wafer is removed from at least one of the plurality of wafer holders, the ion beam to be radiated to the wafer holders from the ion beam generating means is blocked. By this, as described above, the cooling efficiency of a wafer by cooling water is improved.

The above and other features and advantages of the present invention will become apparent to those skilled in the art from the detailed description with reference to the accompanying drawings, which follows.

### Brief Description of the Drawings

FIG. 1 is a schematic view showing an embodiment of an ion implantation apparatus of the present invention;
FIG. 2 is a perspective view of the ion implantation apparatus shown in FIG. 1;
FIG. 3 is a perspective view showing a specific structure of a mass resolving section shown in FIG. 1;
FIG. 4 is a plan view of an arm of a wafer supporting unit shown in FIG. 1;
FIG. 5 is a cross-sectional view taken along line V-V of FIG. 4; and
FIG. 6 is a flowchart showing ion implantation treatment procedures by a control unit shown in FIG. 1.

### Best Mode for Carrying Out the Invention

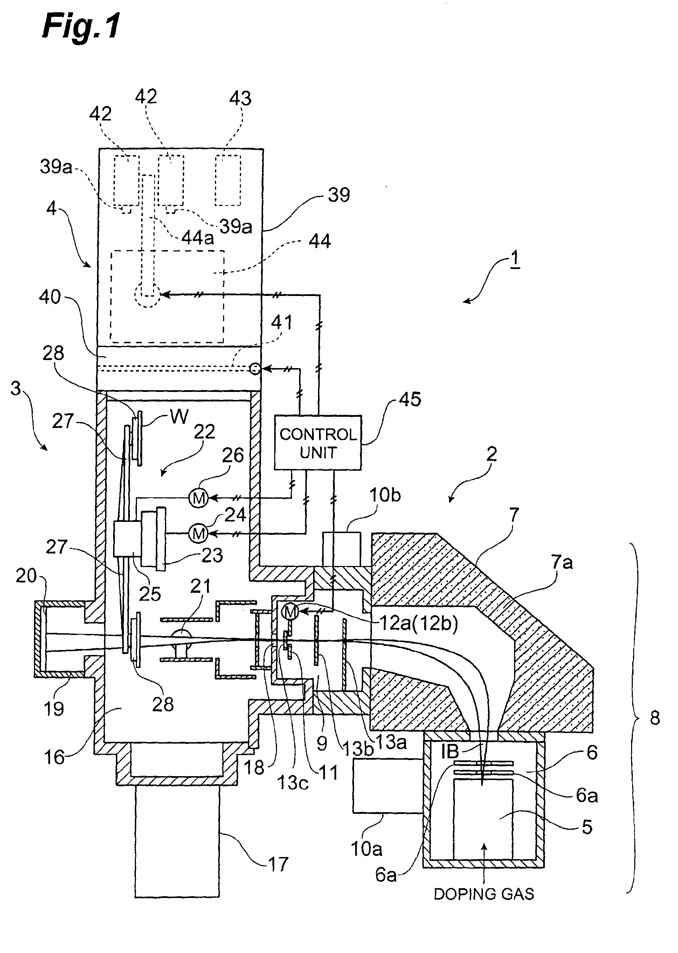

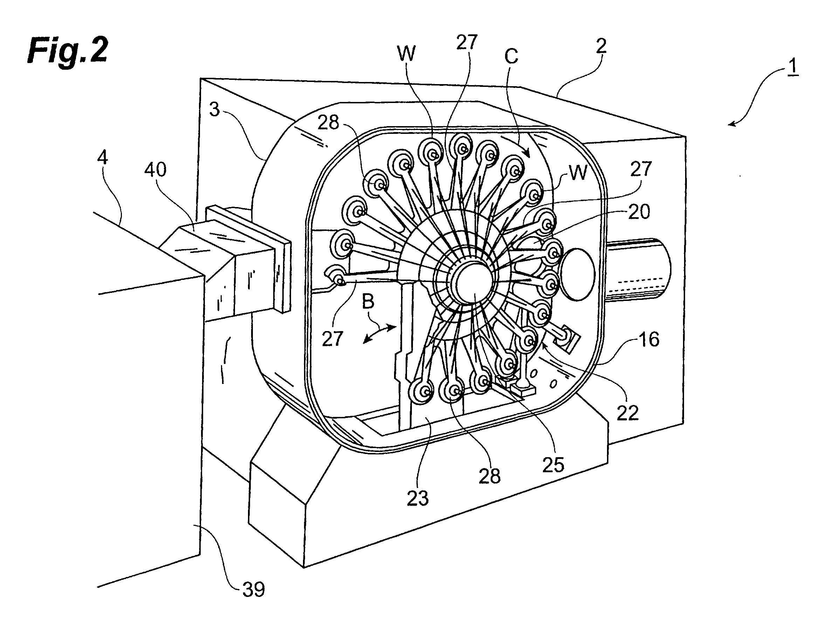

The preferred embodiments of the present invention will be described below in detail with reference to the accompanying drawings. FIG. 1 is a structural view schematically showing an embodiment of an ion implantation apparatus according to the present invention, and FIG. 2 is a perspective view of the ion implantation apparatus. AS shown in FIG. 1, the ion implantation apparatus 1 includes a beam line section 2 for generating an ion beam IB, an ion implantation section 3 for directing the ion beam IB from the beam line section 2 toward a silicon wafer W to implement ion implantation therein, and a wafer loader section 4 for loading wafers W to the ion implantation section 3.

The beam line section 2 is constituted by an ion beam generating section 8 which comprises an ion source 5, ion beam extraction-acceleration system 6 and a mass spectrometric system 7, and amass resolving section 9. Each of the systems is surrounded by a housing or a tube the inside of which is decompressed to a predetermined degree of vacuum by a vacuum pump 10a or 10b.

The ion source 5 produces a high density plasma state by discharging a doping gas fed from a not-shown gas supply source. The ion beam extraction-acceleration system 6 includes a pair of extraction electrodes 6a and 6a. When a negative voltage is applied between the extraction electrodes 6a and 6a, ions constituting the plasma are extracted and accelerated, so that the ion beams IB can be formed. The mass spectrometric system 7 includes a magnet section 7a which can adjust the magnetic field strength, so as to extract only a desired ion species out of the ion beams IB.

The mass resolving section 9 permits only the desired ion beam IB of the ion beams IB extracted from the mass spectrometric system 7 to pass. The section 9 includes an open/close mechanism 11 which can adjust the width of an opening for passing and blocking the ion beam IB from the ion beam generating section 8, driving motors 12a, 12b for opening and closing the open/close mechanism 11, and slits 13a to 13c which are disposed in the vicinity of the mechanism 11 and through which the ion beam IB can pass.

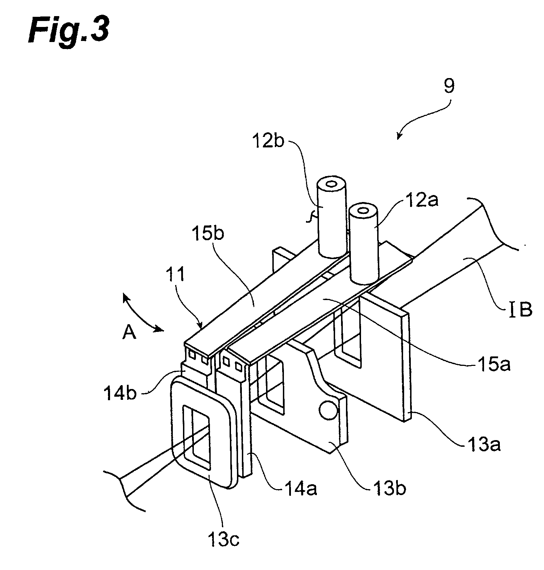

FIG. 3 shows a specific structure of this mass resolving section 9. AS shown in Fig. 3, the open/close mechanism 11 includes a pair of shutter plates 14a, 14b disposed at the rear side (side of the mass specrometric system 7) of the slit 13c. Upper ends of the shutter plates 14a, 14b are connected with ends of operation pieces 15a, 15b extending rearward, respectively. The other ends of the operation pieces 15a, 15b are connected with rotation portions of the driving motors 12a, 12b. Each of the shutter plates 14a, 14b can be swung by the driving motors 12a, 12b along the directions of arrows Awithin a predetermined angle range. Incidentally, the shutter plates 14a, 14b are designed to be swung by the same angle in the directions opposite to each other by signals from a control unit 45 described later and to open and close the beam path.

Now referring back to FIG. 1 and FIG. 2, the ion implantation section 3 includes a target chamber 16 connected with the mass resolving section 9, and the pressure of the inside of the target chamber 16 is reduced to a predetermined degree of vacuum by a cryopump 17.

In a wall portion defining the target chamber 16, an aperture portion 18 for entrance of the ion beam IB is formed at a junction to the mass resolving section 9. A Faraday box 19 is mounted to a portion opposite to the aperture portion 18. In the Faraday box 19, a beam stop 20 for receiving the ion beam IB is disposed. The beam stop 20 includes a not-shown ion detector for detecting a dose of ion beam. A plasma shower 21 is located at a position where the ion beam IB passes in the target chamber 16. The plasma shower 21 functions to prevent the wafer W from being charged up when the ion beam IB is injected into the wafer W.

A wafer supporting unit 22 for supporting the wafer W to be subjected to ion implantation is disposed in the target chamber 16. The wafer supporting unit 22 has a swing shaft 23 which is swingably attached in the target chamber 16, and this swing shaft 23 can be swung by a driving motor 24 along the directions of arrows B in FIG. 2 within a predetermined angle range. A hub 25 is rotatably mounted at the distal end of the swing shaft 23. The hub 25 is rotationally driven in the direction of an arrow C in FIG. 2 by a driving motor 26. A plurality of arms 27 radially extend from the hub 25, and a wafer holder 28 by which the wafer W is held is provided at the distal end of each arm 27.

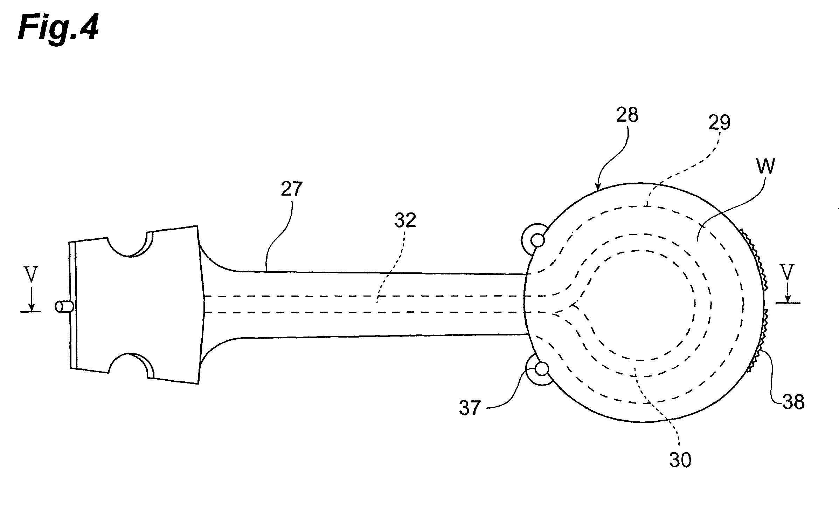

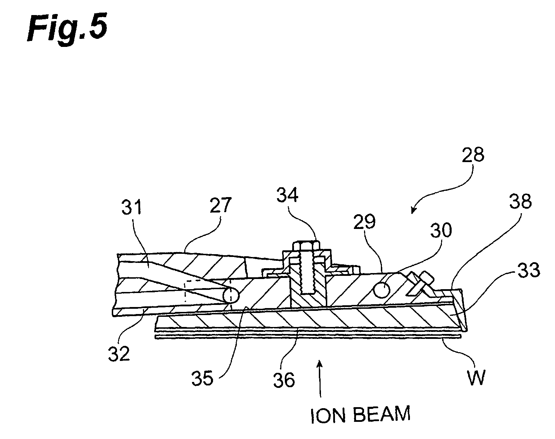

FIGS. 4 and 5 show a specific structure of the wafer holder 28. In these figures, the wafer holder 28 has a circular heat sink paddle 29 mounted at the distal end of the arm 27, and a cooling water path 30 is formed in the heat sink paddle 29. The cooling water path 30 is in communication with a supplying cooling water path 31 and a returning cooling water path 32 which are formed in the arm 22 between a base end and the distal end thereof.

A circular heat sink insert 33 of metal is fixed on the surface of the heat sink paddle 29 with fixture 34. An elastic sheet 35 having thermal conductivity is disposed between the heat sink paddle 29 and the heat sink insert 33 so as to obtain excellent thermal conductivity between the both 29 and 33. An elastic sheet 36 having thermal conductivity is attached on the surface of the heat sink insert 33, and the wafer W is mounted on the surface of the elastic sheet 36. Further, the heat sink paddle 29 has a wafer restraint 38 and stoppers 37 having a spring (not shown) . The wafer restraint 38 and the stoppers 37 can keep the wafer W from slipping off the elastic sheet 36, when the wafer W rests on the surface of the elastic sheet 36.

Again, in FIGS. 1 and 2, the wafer loader section 4 has a load lock chamber 39 located adjacent to the target chamber 11, and the interior of the load lock chamber 39 is decompressed to a vacuum by a not-shown vacuum pump. A transfer passage 40 is formed between the load lock chamber 39 and the target chamber 16, and an isolation valve 41 is interposed in the transfer passage 40 to isolate the load lock chamber '39 from the target chamber 16.

Inside the load lock chamber 39 there is provided a cassette mount section K on which wafer storage cassettes 42, 43 are mount. The wafer storage cassette 42 is a cassette for accommodating a plurality of wafers W to be subjected to ion implantation, and a plurality of (e.g. two) cassettes are mount on the cassette mount section K. The wafer storage cassette 43 is a cassette for accommodating a plurality of dummy wafers Wd. The "dummy wafer Wd" herein is a wafer for protecting the surface of the elastic sheet 36 of the wafer holder 28 while, for example, ion implantation is not carried out, and as the dummy wafer, one having the same shape and weight as the wafer W to be subjected to ion implantation is used. Incidentally, the dummy wafer does not always have to be limited to the same as the wafer W to be subjected to ion implantation, but may be any thing that can protect the surface of the elastic sheet 36. However, use of the same as the wafers W to be subjected to ion implantation eliminates the need for fabrication of extra dummy wafers.

The cassette mount section K is provided with cassette detecting sensors 39a. The sensors 39a monitor whether or not the wafer storage cassettes 42 with the wafers W to be subjected to ion implantation are located at predetermined positions.

Besides, a wafer transfer robot 44 for transferring a wafer W to the position of each wafer holder 28 in the wafer supporting unit 22 is installed in the load lock chamber 39. The wafer transfer robot 44 includes a carry arm 44a which can be rotated and slid by a plurality of not-shown actuators. By operating this carry arm 44a, the robot 44 can pick up a wafer W in the wafer storage cassette 42, 43, mount the wafer W on the surface of the elastic sheet 36 of the wafer holder 28, dismount a wafer W from the elastic sheet 36 and return it into the cassette 42, 43.

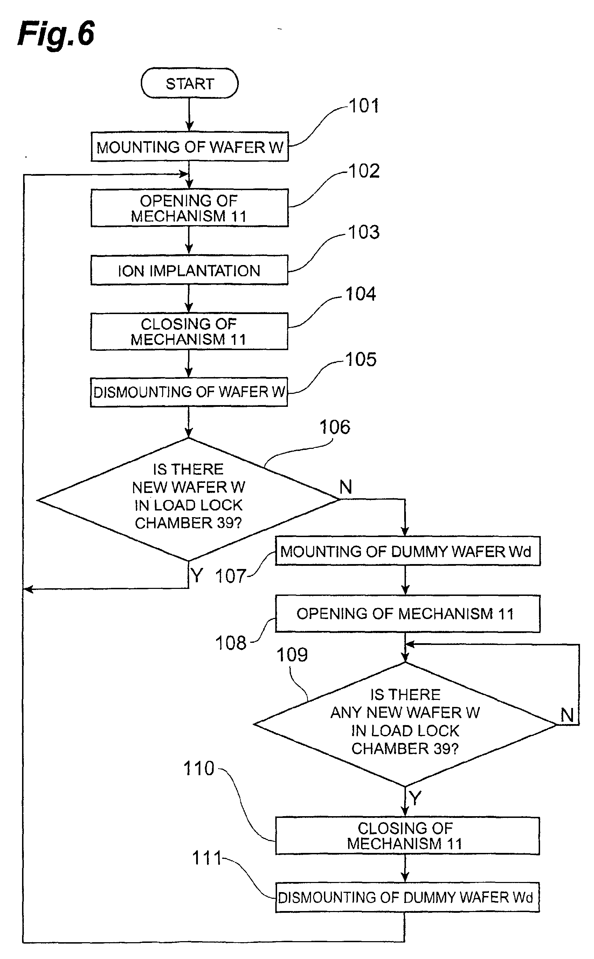

The driving motors 12a, 12b of the foregoing open/close mechanism 11, the driving motors 24, 26 of the wafer supporting unit 22, the isolation valve 41, and the actuators of the wafer transfer robot 44 are driven by control signals from the control unit 45. FIG. 6 shows the procedures of the ion implantation process by this control unit 45. Incidentally, the flowchart of FIG. 6 is based on the premise that the start-up and adjustment of the ion beam IB by the beam line section 2 have already been carried out.

First, when a start of ion implantation operation is instructed by an instruction switch or the like (not shown) , the isolation valve 41 is controlled to be opened, and the respective actuators of the wafer transfer robot 44 are controlled, so that the wafer W stored in the wafer storage cassette 42 is mounted on the surface of the wafer holder 28 (step 101). At this time, the wafer supporting unit 22 is located at a wafer mounting position where the ion beam IB does not impinge on the wafer holders 28, and the control unit controls the wafer transfer robot 44 and also controls the driving motor 26 to rotate the wafer supporting unit 17, thereby successively mounting the wafers W on the surfaces of respective wafer holders 28. Subsequently, when it is determined that the wafers W are mounted on all the wafer holders 28, for example, on the basis of signals from a not-shown sensor provided in the target chamber 16, the control unit controls the driving motors 12a, 12b to open the open/close mechanism 11 (step 102).

Then, the control unit controls the isolation valve 41 to be closed, and also controls the driving motors 24, 26 to rotate the wafer supporting unit 22 at constant high speed and swing it from the wafer mounting position, and then the control unit initiates ion implantation (step 103).

Subsequently, when it is determined that the ion implantation has been completed for all the wafers W on the basis of signals from the ion detector in the beam stop 20 and a time measured by an internal timer, the control unit controls the driving motors 12a, 12b to close the open/close mechanism 11 (step 104). Then, the control unit controls the driving motor 24 to move the wafer supporting unit 22 to the wafer mounting position, and controls the isolation valve 41 to be opened. Then, the control unit controls the respective actuators of the wafer transfer robot 44 to dismount the wafers W from the respective wafer holders 28 and return into the wafer storage cassette 42 (step 105).

Subsequently, on the basis of signals from the cassette detecting sensor 39a, it is judged whether or not the wafer storage cassette 42 in which new wafers W to be continuously subjected to ion implantation are accommodated is placed at a predetermined position of the cassette mount section K (step 106). When it is determined that the wafer storage cassette 42 is present, the procedures proceed to the foregoing step 101.

On the other hand, when it is determined that such a wafer storage cassette 42 is absent, the control unit controls the respective actuators of the wafer transfer robot 44 to mount the dummy wafers Wd accommodated in the wafer storage cassette 43 on the surfaces of the respective wafer holders 28 (step 107). Thereafter, the control unit controls the isolation valve 41 to be closed. Subsequently, when it is determined that the dummy wafers Wd are mounted on all the wafer holders 28 on the basis of signals from the aforementioned sensor (not shown), the control unit controls the driving motors 12a, 12b to open the open/close mechanism 11 (step 108).

Then, from the detection signal of the cassette detecting sensor 39a, it is determined whether or not the wafer storage cassette 42 in which new wafers W to be subjected to next ion implantation are stored is placed at a predetermined position of the cassette mount section K (step 109). Then, when it is determined that the wafer storage cassette 42 is present, the control unit controls the driving motors 12a, 12b to close the open/close mechanism 11 (step 110). Subsequently, the control unit controls the isolation valve 41 to be opened, and the wafer transfer robot 44 to dismount the dummy wafers Wd from the respective wafer holders 28 and return into the wafer storage cassette 43 (step 111). Thereafter, the processing after the foregoing step 101 is executed.

Incidentally, in the above-mentioned procedures, although the open/close mechanism 11 is controlled to be opened after the wafers W and the dummy wafers Wd are mounted on the respective wafer holders 28 (steps 101, 102, 107 and 108), the open/close mechanism 11 may be controlled to be opened immediately before the wafers W and the dummy wafers Wd are mounted.

Described below is an ion implantation method according to the present invention, using the ion implantation apparatus 1 constructed as described above.

First, in the state where the open/close mechanism 11 is closed, the isolation valve 41 is opened, and the carry arm 44a of the wafer transfer robot 44 is operated, so that wafers W in the wafer storage cassette 42 are mounted on the surfaces of the respective wafer holders 28 (step 101 of FIG. 6). Then, the open/close mechanism 11 is opened to let the ion beam IB pass through a space between the pair of shutter plates 14a, 14b (step 102 of FIG. 6). Then, the isolation valve 41 is closed, and the ion beam IB is radiated to the entire surfaces of all the wafers W to effect ion implantation therein (step 103 of FIG. 6).

After completion of the ion implantation for all the wafers W, the open/close mechanism 11 is closed to block the ion beam IB (step 104 of FIG. 6). Then, the isolation valve 41 is opened, and the wafers W are dismounted from the wafer holders 28 and returned into the wafer storage cassette 42 (step 105 of FIG. 6). At this time, since the ion beam IB is blocked by the open/close mechanism 11, there does not occur such a state that the ion beam IB is implanted into the beam stop 20 to produce particles . Also, particles produced by impingement of the ion beam IB against the open/close mechanism 11 are sucked out to the outside of the mass resolving section 9 by the vacuum pump 10b and do not enter the target chamber 16 from the aperture portion 18. Accordingly, even if the surface of the wafer holder 28 is exposed, contaminants by sputtering of the ion beam or the like hardly deposit to the surface of the elastic sheet 36.

Subsequently, if the wafer storage cassette 42 inwhich new wafers W to be continuously subjected to ion implantation are stored is present at a predetermined position in the load lock chamber 39, the new wafers W are continuously mounted on the surfaces of the respective wafer holders 28 (step 106 → 101 of FIG. 6), and ion implantation is carried out for the wafers W.

On the other hand, if the wafer storage cassette 42 in which new wafers W are stored is not present at a predetermined position in the load lock chamber 39, the dummy wafers Wd stored in the wafer stroage cassette 43 are mounted on the surfaces of the respective wafer holders 28 by the wafer transfer robot 44 (step 107 of FIG. 6). During the mounting of the dummy wafers Wd, since the open/close mechanism 11 remains closed, it can prevent contaminants from depositing on the surface of the elastic sheet 36 as described above. Then, the open/close mechanism 11 is opened, and the ion beam IB is made to pass through a space between the pair of shutter plates 14a, 14b (step 108 of FIG. 6). After that, the isolation valve 41 is closed.

Thereafter, the operator takes out all the wafer storage cassettes 42, in which the wafers W after the ion implantation are accommodated, to the outside of the load lock chamber 39, transfers the wafer storage cassette 42, in which new wafers W are accommodated, into the load lock chamber 39, and sets it at a predetermined position of the cassette mount section K. At this time, since the inside of the load lock chamber 39 is opened to the atmosphere, the pressure of the inside of the load lock chamber 39 is reduced to a desired degree of vacuum by a not-shown vacuum pump. During this, since the open/close mechanism 11 is opened, the ion beam IB is implanted into the beam stop 20, but since the surfaces of the respective wafer holders 28 are protected by the dummy wafers Wd, particles cannot adhere to the surfaces of the elastic sheets 36.

Thereafter, the open/close mechanism 11 is closed, and the ion beam IB is blocked (step 109 → 110 of FIG. 6). Then, the isolation valve 41 is opened, and the dummy wafers Wd are dismounted from the respective wafer holders 28 by the wafer transfer robot 44 and returned into the wafer storage cassette 43 (step 111 of FIG. 6). At this time, since the open/close mechanism 11 remains closed, it can prevent contaminants from attaching to the surfaces of the elastic sheets 36 as described above. Then, the new wafers W accommodated in the wafer accommodating cassette 42 are mounted on the surfaces of the respective wafer holding bodies 28, and ion implantation is carried out to the wafers W.

As described above, in this embodiment, when the wafers W and the dummy wafers Wd are mounted on and dismounted from the respective wafer holders 28, the open/close mechanism 11 is closed to block the ion beam IB, and after the wafers W are removed from the respective wafer holders 28, the dummy wafers Wd are mounted on the surfaces of the respective wafer holders 28, so that contaminants hardly deposit to the surfaces of the elastic sheets 36. Thus, when the wafer W is mounted on the surface of the wafer holder 28, the back surface of each wafer W can be kept in contact with the surface of the elastic sheet 36 across the almost entire surface. This yields high thermal conductivity between the elastic sheet 36 and the wafer W, thereby enhancing the cooling efficiency of wafer W with the cooling water flowing in the cooling water path 30 in the heat sink paddle 29.

If after dismounting of the wafers W from the respective wafer holders 28 there are wafers W to be subsequently subjected to ion implantation in the load lock chamber 39, the wafers W immediately mounted on the surfaces of the respective wafer holders 28, whereby the ion implantation process can be performed efficiently.

Incidentally, in this embodiment, after the wafers W subjected to ion implantation are dismounted from the respective wafer holders 28, the dummy wafers Wd are mounted on the surfaces of the respective wafer holders 28, but such dummy wafers Wd may not be used and the open/close mechanism 11 may be put in a state where it remains closed when the wafers W are not mounted on the surfaces of the respective wafer holders 28.

Although in the present embodiment the scan on the wafers W with the ion beam IB was implemented by the rotation and swing motions of the wafer supporting unit 22, the present invention does not always have to be limited to this particular configuration but can also be applied to ion implantation apparatus of a type moving the ion beam itself, for example.

### Industrial Applicability

According to the present invention, when wafers are not held by the respective wafer holders, the open/close mechanism is closed to block ion beam from the ion beam generating means. Therefore, sputtering to the beam stop in the target chamber is prevented, and contaminants hardly attach to the wafer holding means. Accordingly, in a next ion implantation process, excellent thermal conductivity is obtained between the wafer and the wafer holding means, thus the cooling efficiency of the wafer by cooling water is improved.

As a consequence, the present invention makes it feasible to be ready for enhancement of performance of devices in the fields of fabrication of electro-microdevices such as semiconductor devices and others.

## Claims

1. An ion implantation apparatus comprising:
a target chamber under vacuum inside;
a wafer holder disposed in said target chamber;
ion beam generating means for generating an ion beam to be radiated to a wafer held by said wafer holder;
an open/close mechanism disposed between said target chamber and said ion beam generating means, for passing and blocking the ion beam from said ion beam generating means;
driving means for opening and closing said open/close mechanism;
a load lock chamber disposed adjacent to said target chamber and kept under vacuum inside;
wafer transfer means disposed in said load lock chamber; and
control means for controlling said driving means and said wafer transfer means,
wherein said control means controls said driving means and said wafer transfer means so that said open/close mechanism is opened after the wafer is held by said wafer holder, and said control means controls said driving means and said wafer transfer means so that the wafer is dismounted from said wafer holder after said open/close mechanism is closed.

2. The ion implantation apparatus according to claim 1, wherein said control means controls said driving means and said wafer transfer means so that after the wafer is dismounted from said wafer holder, a dummy wafer is held by said wafer holder and said open/close mechanism is opened.

3. The ion implantation apparatus according to claim 2, wherein after the wafer is dismounted from the wafer holder, said control means monitors whether or not a wafer to be continuously subjected to ion implantation is present in said load lock chamber, and when it is determined that said wafer to be continuously subjected to ion implantation is present, said control means controls said driving means and said wafer transfer means so that said open/close mechanism is opened after said wafer to be continuously subjected to ion implantation is held by said wafer holder, and when it is determined that said wafer to be continuously subjected to ion implantation is absent, said control means controls said driving means and said wafer transfer means so that said open/close mechanism is opened after the dummy wafer is held by said wafer holder.

4. An ion implantation apparatus comprising:
a target chamber under vacuum inside;
a wafer holder disposed in said target chamber;
ion beam generating means for generating an ion beam to be radiated to a wafer held by said wafer holder;
an open/close mechanism disposed between said target chamber and said ion beam generating means, for passing and blocking the ion beam from said ion beam generating means;
driving means for opening and closing said open/close mechanism; and
control means for controlling said driving means so that said open/close mechanism is closed when the wafer is dismounted from said wafer holder.

5. An ion implantation apparatus for carrying out ion implantation by radiating a wafer with an ion beam, comprising means for selectively passing or blocking the ion beam, disposed on a path of the ion beam.

6. An ion implantation method for carrying out ion implantation by using an ion implantation apparatus having a target chamber under vacuum inside, a wafer holder disposed in said target chamber, ion beam generating means for generating an ion beam to be radiated to a wafer held by said wafer holder, and an open/close mechanism disposed between said target chamber and said ion beam generating means, for passing and blocking the ion beam from the ion beam generating means, said ion implantation method comprising:
afirststepof opening said open/closemechanism after said wafer is held by said wafer holder;
a second step of carrying out ion implantation by radiating said wafer with said ion beam; and
a third step of dismounting said wafer from said wafer holder after said open/close mechanism is closed when the ion implantation to said wafer is completed,
wherein said first to third steps are carried out repeatedly while radiation of said ion beam is maintained.

7. The ion implantation method according to claim 6, further comprising a fourth step of opening the open/close mechanism after a dummy wafer is held by said wafer holder, between said third step and said first step.

8. An ion implantation method for carrying out ion implantation by radiating a wafer held by each of a plurality of wafer holders with an ion beam from ion beam generating means,
wherein when said wafer is dismounted from at least one of said wafer holders, ion radiation is continued, and said ion beam to be radiated to said wafer holders from said ion beam generating means is blocked.
